# FASCICULE DE BREVET EUROPEEN

(11) **EP 1 982 202 B1**
(45) Date de publication et mention de la délivrance du brevet: **07.07.2010**
(21) Numéro de dépôt: 07704273.7
(22) Date de dépôt: 31.01.2007
(51) Int. Cl.: G01R 31/265, G01R 31/28

(54) **SOURCE LUMINEUSE ÉTENDUE ET ÉLECTRIQUEMENT MODULABLE, DISPOSITIF DE MESURE POUR CARACTÉRISER UN SEMI-CONDUCTEUR COMPORTANT UNE TELLE SOURCE**
ELEKTRISCH MODULIERBAR ERWEITERTE LICHTQUELLE UND MESSEINRICHTUNG ZUR CHARAKTERISIERUNG EINES EINE SOLCHE QUELLE ENTHALTENDEN HALBLEITERS
ELECTRICALLY-MODULATABLE EXTENDED LIGHT SOURCE AND A MEASUREMENT DEVICE FOR CHARACTERISING A SEMICONDUCTOR INCLUDING ONE SUCH SOURCE

(30) Priorité: 03.02.2006 FR 0650388
(43) Date de publication de la demande: 22.10.2008
(73) Titulaire: UNIVERSITE PAUL CEZANNE AIX-MARSEILLE III, 13628 Aix en Provence Cedex 1 (FR)
(72) Inventeur: PALAIS, Olivier, F-13013 Marseille (FR); PASQUINELLI, Marcel, F-13119 St Savournin (FR)
(74) Mandataire: Schmit, Christian Norbert Marie
(86) Numéro de dépôt international: PCT/EP2007/050950
(87) Numéro de publication internationale: WO 2007/088176

(56) Documents cités:
- US-A1- 2005 196 882
- O. PALAIS, A.ARCARI: "Contactless measurement of bulk lifetime and surface recombination velocity in silicon wafers" JOURNAL OF APPLIED PHYSICS, vol. 93, no. 8, 15 avril 2003 (2003-04-15), pages 4686-4690, XP002397643 cité dans la demande
- PATENT ABSTRACTS OF JAPAN vol. 2000, no. 09, 13 octobre 2000 (2000-10-13) -& JP 2000 154094 A (HORIBA LTD), 6 juin 2000 (2000-06-06)
- PALAIS O ET AL: "Mapping of minority carrier lifetime and mobility in imperfect silicon wafers" MATERIALS SCIENCE AND ENGINEERING B, ELSEVIER SEQUOIA, LAUSANNE, CH, vol. 102, no. 1-3, 15 septembre 2003 (2003-09-15), pages 184-188, XP004450726 ISSN: 0921-5107

## Description

La présente invention concerne une source lumineuse étendue et électriquement modulable destinée à injecter des porteurs en excès dans une tranche semi-conductrice en l'éclairant. En particulier, cette source en s'associant à un dispositif de mesure permet de caractériser des propriétés électriques de cette tranche semi-conductrice, telles que la durée de vie volumique et la vitesse de recombinaison superficielle des porteurs minoritaires d'une tranche semi-conductrice. L'invention s'applique plus particulièrement au domaine de l'industrie du photovoltaïque et de la microélectronique.

Les nouveaux composants électroniques et la génération future des dispositifs au sein de la technologie microélectronique, et en particulier dans le domaine de l'Intégration à Très Grande Echelle des circuits intégrés exigent des matériaux de départ des niveaux de pureté de plus en plus grande, il en va de même pour les cellules photovoltaïques. Les métaux sont les principaux responsables de contamination des tranches de silicium. La présence de ces métaux diminue les performances, la fiabilité et le rapport des dispositifs, à savoir le nombre de « bon » dispositifs d'une tranche de silicium divisé par le nombre total de dispositifs de cette même tranche. Par exemple dans les transistors, les métaux alcalis introduisent une charge mobile dans la fine couche d'oxyde qui neutralise alors les propriétés d'isolement des oxydes. De même les métaux de transition agissent comme des pièges à électrons. Ainsi une concentration d'impuretés supérieure à 10¹⁰cm⁻³ peut rendre une tranche de silicium totalement inutilisable pour la fabrication de certains dispositifs.

Ainsi la contamination constitue une menace relativement coûteuse pour l'industrie de la microélectronique et il est donc essentiel de mesurer et contrôler cette contamination au cours du processus de fabrication des circuits intégrés.

Par ailleurs, si pour l'industrie photovoltaïque la menace est jugée moins critique, les contaminations métalliques peuvent dégrader le rendement de conversion des cellules et peuvent alors exercer un impact certain sur le prix de vente du produit final.

Les techniques physico-chimiques traditionnellement utilisées pour mesurer la contamination ne sont pas applicables à un contrôle en ligne. Il fallait extraire de la tranche les solutions aqueuses des contaminations métalliques et les mesurer ensuite selon des méthodes spectroscopiques. Ces techniques sont trop longues, trop coûteuses et destructrices, donc non applicables pour une utilisation en ligne.

Des techniques basées sur la mesure des effets électriques de la contamination plutôt que la concentration des impuretés sont proposées telle que la technique de décroissance de la photoconductivité en hyperfréquence (micro-PCD). Ces techniques consistent à mesurer la durée de vie des porteurs minoritaires τ_{b} dans la tranche semi-conductrice, la durée de vie des porteurs minoritaires étant un paramètre relié à la concentration d'impuretés.

Cependant, la mesure de ce paramètre τ_{b} est liée à la vitesse de recombinaison superficielle S, et il n'est pas facile d'en extraire directement sa valeur. Les techniques alternatives proposées mesurent généralement une durée de vie effective τ_{eff} qui est reliée à la fois à τ_{b} et S. Afin de pouvoir extraire τ_{b}, il faut donc soit déterminer de façon très précise la valeur de S soit rendre la vitesse de recombinaison S négligeable par rapport à τ_{b}. Généralement la solution proposée consiste en une étape supplémentaire de passivation de la surface des tranches de silicium avant l'étape de mesure. Cependant cette étape de passivation de surface n'est pas très adaptée pour être mise sur une ligne de production, car elle risque d'une part d'endommager la tranche et d'autre part elle induit un délai supplémentaire dans le processus de mesure et de contrôle de qualité de la tranche, entraînant par conséquent un surcoût de production.

Le document O.Palais, A. Arcari, "Contactless measurement of bulk lifetine and surfacerecombination velocity in silicon wafers", Journals of Applied Physics, A. Arcari, "Contractless measurement of bulk lifetime and surface recombination velocity in Silicon wafers" Journal of Applied Physics, vol. 93, no. 8, 15 April 2003 ; pp.4686-4690. décrit une autre technique alternative de mesure basée sur la mesure du déphasage micro-onde entre le signal de modulation d'une source excitatrice lumineuse et les micro-ondes réfléchies par une tranche semi-conductrice ainsi éclairée par la source excitatrice lumineuse. Contrairement aux techniques précédemment citées, cette technique permet d'accéder indépendamment à la durée de vie volumique des porteurs minoritaires τ_{b} et aux vitesses de recombinaisons superficielles S dans la tranche semi-conductrice sans avoir à procéder à une passivation des surfaces de la tranche.

Le dispositif comprend deux sources. La première source est une source photonique excitatrice laser émise dans le proche infrarouge modulée à une basse fréquence f. Cette source émettant un faisceau lumineux monochromatique d'un diamètre compris entre 25 et 50µm éclaire localement une des deux faces de la tranche semi-conductrice, et crée ainsi dans l'échantillon une certaine population de porteurs en excès. La deuxième source est une source sonde micro-onde qui émet un champ micro-onde à 10 GHz. Cette deuxième source micro-onde irradie le même échantillon en même temps que la première source mais par la face non éclairée par la première source. Les propriétés des micro-ondes réfléchies dépendent de la densité ou population de porteurs induite par la première source laser, en mesurant le déphasage Δφ des micro-ondes de la réflexion en fonction de la fréquence de modulation f, on peut déterminer les propriétés électriques de la tranche qui sont la durée de vie volumique τ_{b} et la vitesse de recombinaison superficielle S des porteurs minoritaires.

Cependant ce dispositif permet surtout d'établir une cartographie de durée de vie volumique de la tranche. En effet le dispositif de mesure associé à cette technique de mesure comporte une petite source modulée sinusoïdalement autour d'un niveau d'éclairement constant. Ce dispositif permet seulement de mesurer localement la durée de vie des porteurs de la tranche, il faut donc répéter les mesures pour pourvoir balayer toute la surface de la plaquette en déplaçant la source excitatrice photonique zone par zone afin d'établir une cartographie (S, τ_{b}) de la tranche. Ce dispositif nécessite donc un temps de mesure relativement long pour obtenir les données de durée de vie des porteurs pour toute la tranche, généralement la durée d'établissement des cartographies nécessite plusieurs heures. De ce fait, cette source rend la technique de mesure et le dispositif associé inadaptée pour des mesures de durée de vie volumique et de contrôle de contamination d'impuretés en ligne.

Or dans l'industrie de la microélectronique et du photovoltaïque, il est impératif d'avoir une technique de mesure simple, pouvant effectuer la mesure rapidement et s'adapter à la taille de la tranche semi-conductrice.

L'objectif de l'invention est de proposer une source lumineuse simple dans sa conception et dans son mode opératoire permettant des mesures globales sur un échantillon, notamment cette source associée à un dispositif de mesure permet de déterminer en ligne rapidement et efficacement une durée de vie volumique τ_{b} et les vitesses de recombinaison superficielles S des porteurs minoritaires d'une tranche semi-conductrice au cours du processus de fabrication des circuits intégrés et des cellules photovoltaïques, ce qui permet entre autre, de mettre en évidence une éventuelle contamination métallique par le biais de la mesure de la durée de vie des porteurs minoritaires.

En particulier, cette source doit s'adapter à tout type de matériau de la tranche semi-conductrice et elle doit éclairer de manière homogène toute la surface de la tranche quelque soit sa taille permettant ainsi d'effectuer des mesures globales et obtenir en une seule mesure une valeur moyenne de la durée de vie volumique et de la vitesse de recombinaison des porteurs minoritaires.

A cet effet l'invention concerne une source lumineuse destinée à injecter des porteurs en excès dans une tranche semi-conductrice en éclairant entièrement une surface de cette tranche semi-conductrice.

Selon l'invention, cette source comporte au moins un ensemble de sources ponctuelles espacées à intervalles réguliers dans la direction X et dans la direction Y, de sorte que cette source émette un faisceau monochromatique dont la dimension est au moins égale à celle de la surface à éclairer de ladite tranche semi-conductrice, chacune de ces sources ponctuelles étant modulée sinusoïdalement par un modulateur électrique commun, la distance (d) entre deux source ponctuelles et la distance (D) entre la source et la surface à éclairer de la tranche étant choisies de sorte que le faisceau lumineux monochromatique éclaire de manière uniforme la surface à éclairer de la tranche.

Dans différents modes de réalisation possibles, la présente invention concerne également les caractéristiques qui ressortiront au cours de la description qui va suivre et devront être considérées isolément ou selon toutes leurs combinaisons techniques possibles :
- le modulateur électrique module les sources dans une gamme de fréquence comprise entre 1 Hz et 100kHz,
- dans un mode de réalisation particulier, chaque source ponctuelle est une diode laser fibrée,
- dans un autre mode de réalisation particulier, chaque source ponctuelle est une diode électroluminescente,
- la distance d'intervalle (d) entre deux diodes est comprise de préférence entre 0cm et 1.5cm,
- un filtre neutre de diffusion est placé de préférence entre la source et la face à éclairer de l'objet pour rendre le faisceau lumineux émis par la source plus uniforme.

L'invention concerne également un dispositif comprenant cette source lumineuse pour la mesure de la durée de vie volumique et la vitesse de recombinaison superficielle des porteurs minoritaires d'une tranche semi-conductrice, ce dispositif comprend donc en outre :
- le modulateur électrique comportant une sortie pour alimenter la source lumineuse et une sortie de signal de référence de fréquence identique à la fréquence f de modulation de la source lumineuse,
- une source sonde, pour créer un champ d'ondes, les ondes émises irradiant la face non éclairée de ladite tranche semi-conductrice,
- un guide d'onde ou une antenne permettant d'acheminer les ondes émises sur la face non éclairée de ladite tranche semi-conductrice et les ondes réfléchies vers un détecteur micro-onde, ledit guide d'onde ou ladite antenne associé audit détecteur micro-onde étant destiné à recueillir le signal produit par les ondes réfléchies par ladite tranche semi-conductrice ainsi excitée par ladite source lumineuse,
- une unité de contrôle recevant le signal de référence provenant d'une des deux sorties du modulateur électrique et le signal d'ondes réfléchies à la

sortie dudit détecteur, le signal d'ondes réfléchies étant mesuré à la fréquence f du signal de référence,
- une unité de traitement des signaux recevant la mesure du déphasage Δφ des ondes réfléchies de l'unité de contrôle pour extraire deux paramètres de la tranche semi-conductrice qui sont la durée de vie des porteurs minoritaires τ_{b} et la vitesse de recombinaison superficielle S.

Dans différents modes de réalisation possibles, l'invention sera décrite plus en détails en référence aux dessins annexés dans lesquels :
- la figure 1.A représente schématiquement une vue de face d'une source lumineuse de l'invention comportant un ensemble de sources ponctuelles disposées à intervalles réguliers et la figure 1.B est une vue de profil d'une ligne de sources ponctuelles de la figure 2 ;
- la figure 2 est une vue de profil de la source lumineuse en configuration d'éclairement direct sur une tranche semi-conductrice ;
- la figure 3 est une vue de profil de la source lumineuse en configuration d'éclairement indirect sur une tranche semi-conductrice, la source étant disposée à 90° par rapport à la tranche semi-conductrice,
- la figure 4 représente schématiquement un dispositif de mesure comportant une source lumineuse de l'invention pour déterminer la durée de vie volumique et la vitesse de recombinaison superficielle des porteurs minoritaires d'une tranche semi-conductrice

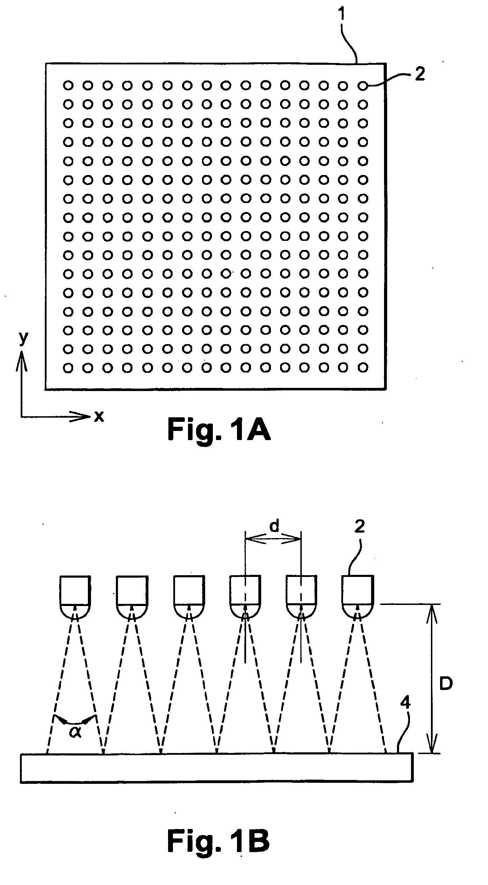

L'invention concerne une source lumineuse destinée à injecter des porteurs en excès dans une tranche semi-conductrice en éclairant une surface de cette tranche semi-conductrice de façon continue et modulée. La figure 1.A représente une vue de dessus d'un exemple de cette source lumineuse qui a une géométrie rectangulaire. La forme de la source peut être également circulaire ou ovale.

La source lumineuse comporte un ensemble de sources ponctuelles 2 espacées à intervalles réguliers dans la direction X et dans la direction Y, formant ainsi un réseau de sources ponctuelles. Toutes ces sources ponctuelles émettent chacune un faisceau monochromatique et la même longueur d'onde de sorte que la source globale émette un faisceau monochromatique. La dimension du faisceau émis par la source 1 est au moins égale à celle de la surface à éclairer de la tranche semi-conductrice.

Avantageusement la distance (d) entre deux sources ponctuelles et la distance (D) entre la source et la surface à éclairer de la tranche semi-conductrice sont choisies de sorte que le faisceau lumineux monochromatique éclaire de manière uniforme toute la surface à éclairer de la tranche semi-conductrice.

Cet éclairement uniforme sur toute la surface d'une tranche semi-conductrice permet de modifier la population de porteurs dans toute la tranche semi-conductrice.

La taille de la source varie en fonction du nombre de sources ponctuelles le constituant, offrant ainsi avantageusement une flexibilité pour adapter facilement la taille du faisceau lumineux émis par la source en fonction de la taille de la tranche semi-conductrice à irradier.

De préférence, pour une mesure de toute la tranche semi-conductrice, la taille du panneau d'éclairement est au moins égale à la taille de la tranche semi-conductrice.

Toutes les sources ponctuelles 2 sont alimentées par un modulateur électrique commun et chacune de ces sources ponctuelles est modulée sinusoïdalement par un modulateur électrique commun à une fréquence f.

De préférence, ce modulateur électrique travaille dans une gamme de fréquence f comprise entre 1 Hz et 100kHz.

Avantageusement, la longueur d'onde du faisceau émis par la source lumineuse est modifiable en fonction du matériau de la tranche semi-conductrice à étudier en remplaçant l'ensemble des sources ponctuelles par d'autres sources ponctuelles ayant une longueur d'onde adéquate.

Dans un mode de réalisation particulier de l'invention, la source lumineuse peut comporter plusieurs ensembles de sources ponctuelles émettant chacun un faisceau monochromatique de longueur d'onde différent. Ainsi pour faire varier la longueur d'onde de la source lumineuse, il suffit choisir l'un des ensembles de sources ponctuelles émettant le faisceau lumineux de longueur d'onde adapté.

Dans un mode de réalisation, la source ponctuelle 2 est une diode laser fibrée et la source lumineuse comporte un ensemble de diodes lasers fibrées. De préférence une lentille de localisation est placée en sortie de chaque diode laser fibrée.

Dans un autre mode de réalisation, chaque source ponctuelle est une diode électroluminescente et la source lumineuse comporte un ensemble de diodes électroluminescentes.

Pour réaliser un faisceau lumineux uniforme sur à toute la surface de la tranche semi-conductrice, il faut généraliser une configuration optimale de disposition de ces sources ponctuelles quelque soit le type de source ponctuelle utilisée.

De préférence, la distance d'intervalle (d) entre deux diodes est comprise entre 0 cm et 1.5 cm de manière à ne pas avoir des zones d'ombres marquées, ni de zones surexposées en raison de recouvrement entre deux petits faisceaux. La distance (D) entre la source lumineuse et la surface à éclairer de la tranche semi-conductrice dépend du type de source utilisée.

Avantageusement cette configuration de disposition des sources ponctuelles peut être généralisée quelque soit l'angle d'émission α des diodes électroluminescentes et quelque soit la distance de focalisation des lentilles placées à la sortie de fibre optique dans le cas où les sources ponctuelles sont des diodes lasers fibrées.

La figure 1.B représente schématiquement un exemple de configuration dans laquelle les sources ponctuelles sont des diodes électroluminescentes ayant un angle d'émission moyen a égal à 30°. La distance entre deux diodes référencée (d) sur la figure 1.B est égale à 1 cm, dans ce cas une distance entre la source lumineuse et la surface à éclairer de la tranche semi-conductrice référencée (D) sur la figure 1.B est égale à 5 cm pour obtenir un éclairement uniforme sur toute la surface de la tranche semi-conductrice.

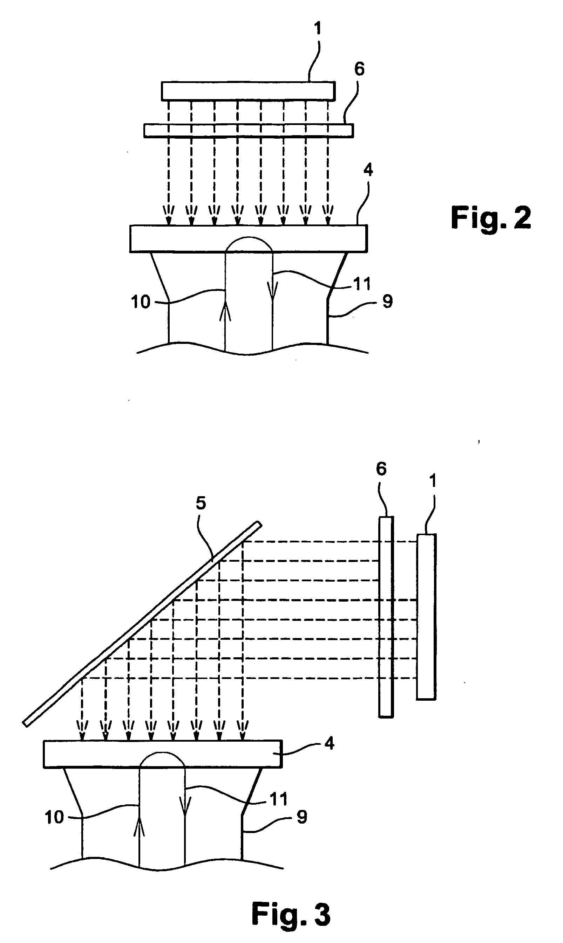

La figure 2 représente une première configuration d'éclairement où la source lumineuse est placée au-dessus de la surface à éclairer de la tranche semi-conductrice.

Dans une autre configuration d'éclairement représentée schématiquement sur la figure 3, la surface de la tranche semi-conductrice est éclairée indirectement par la source qui est placée à 90° par rapport à la surface à éclairer de la tranche semi-conductrice 4. Le faisceau lumineux de la source est alors renvoyé au moyen d'un miroir de renvoi 5 placé à 45° entre la source lumineuse et la tranche semi-conductrice.

De préférence, un filtre neutre de diffusion 6 est placé entre la source et la tranche semi-conductrice pour uniformiser davantage le faisceau lumineux émis par la source lumineuse 1.

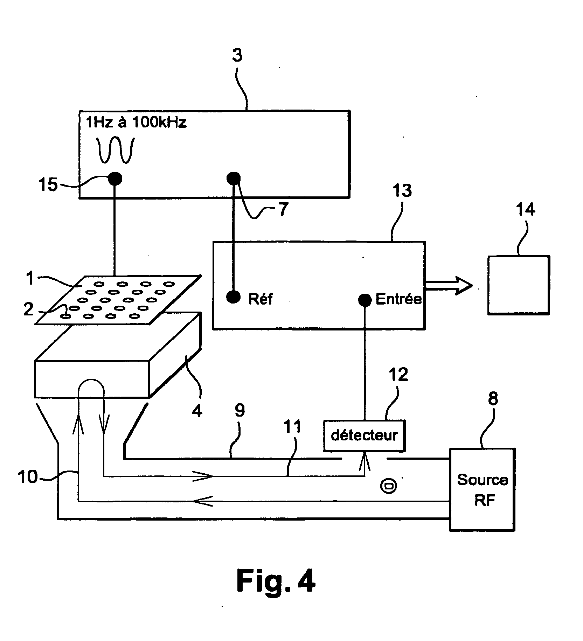

La figure 4 décrit un dispositif de mesure comportant une source lumineuse 1 décrite ci-dessus pour l'étude des matériaux semi-conducteur, ce dispositif étant destiné à des mesures de la durée de vie volumique et de la vitesse de recombinaison superficielle des porteurs minoritaires dans une tranche semi-conductrice 4. Ce dispositif de mesure est basé sur la technique du déphasage des ondes réfléchies par la face non éclairée de la tranche. La source lumineuse éclaire de manière continue et modulée toute la surface de la tranche semi-conductrice, pour y injecter des porteurs libres, le niveau d'injection étant quasi constant durant l'éclairement de la surface de la tranche semi-conductrice. Ainsi cette source crée dans toute la tranche une population de porteurs en excès.

Le dispositif comporte un modulateur électrique 3 qui alimente la source lumineuse via une première sortie 15 et envoie via une autre sortie 7 simultanément un signal de référence à une unité de contrôle 13 pour lui transmettre la référence de phase et la fréquence f de la modulation de la source lumineuse.

Le dispositif comprend en outre une deuxième source sonde onde 8 qui soumet la tranche semi-conductrice à un champ d'ondes par la face non éclairée par la source excitatrice photonique.

De manière générale, la source d'onde est une source micro-onde et on utilise une diode à effet Gunn travaillant en bande X comme source micro-onde.

De préférence, la source micro-onde émet un champ micro-onde à une fréquence de 10 GHz, irradiant ainsi la face non éclairée de la tranche semi-conductrice 4.

Il est possible d'utiliser également une source d'onde radiofréquence, travaillant dans un spectre radio fréquence compris entre la bande VHF et la bande X.

Le principe de la mesure de déphasage micro-onde est le suivant. Lorsque la tranche semi-conductrice 4 est soumise entièrement à la lumière d'excitation sinusoïdalement modulée de la source, une variation globale de densité de porteurs minoritaires est créée, induisant une variation sinusoïdale du coefficient de réflexion des micro-ondes. Un guide d'onde ou une antenne 9 permettant d'acheminer les ondes émises 10 sur la face non éclairée de la tranche semi-conductrice et les ondes réfléchies 11 vers un détecteur micro-onde 12, ce guide d'onde ou cette antenne associé au détecteur étant destiné à recueillir le signal produit par les micro-ondes réfléchies par la tranche semi-conductrice ainsi excitée 4.

En mesurant un déphasage Δφ entre le signal de modulation de la source lumineuse et le signal issu du détecteur 12 des micro-ondes réfléchies, on peut extraire les valeurs de S et τ_{b} qui traduisent les propriétés électriques de la tranche semi-conductrice.

De manière générale, l'unité de contrôle 13 est un phasemètre.

Dans le cas d'un signal bruité et/ou de faible amplitude, l'unité de contrôle 13 est un détecteur synchrone afin d'améliorer le rapport signal sur bruit. Une unité de traitement des signaux 14 est reliée à cette unité de contrôle 13 pour traiter automatiquement à partir des données envoyées par l'unité de contrôle pour extraire les paramètres S et τ_{b}.

Par ailleurs, quelque soit le mode de réalisation de la source lumineuse, pour que la variation de densité de porteurs minoritaires soit suffisante pour induire une variation significative du coefficient de réflexion des micro-ondes, la puissance fournie par la source lumineuse doit permettre une injection de porteurs libres au moins supérieure à 10⁻⁵ fois le dopage de la tranche semi-conductrice.

Avantageusement l'ensemble des différents éléments constituant le dispositif de mesure représenté sur la figure 4 est automatisé par un programme informatique. Et un programme de calcul permet d'extraire automatiquement les paramètres τ_{b} et S à partir des couples mesurés (f, Δφ).

Avantageusement, la source lumineuse de l'invention permet d'effectuer des mesures globales de ces paramètres τ_{b}. S qui sont les propriétés électriques de la tranche semi-conductrice. Ainsi cette source lumineuse associée à un dispositif de mesure de la durée de vie volumique τ_{b} et de la vitesse de recombinaison superficielle S des porteurs minoritaires permet de mesurer et contrôler rapidement et efficacement la contamination métallique et les défauts cristallographiques de la tranche semi-conductrice au cours des différentes étapes du processus de fabrication des circuits intégrés et des cellules photovoltaïques.

## Revendications

1. Source lumineuse destinée à injecter des porteurs en excès dans une tranche semi-conductrice en éclairant une surface de ladite tranche semi-conductrice (4), ladite source étant associée à un dipositif de mesure pour caractériser ladite tranche semi-conductrice, **caractérisée en ce que** ladite source (1) comporte au moins un ensemble de sources ponctuelles (2) espacées à intervalles réguliers dans la direction X et dans la direction Y, de sorte que ladite source émette un faisceau monochromatique dont la dimension est au moins égale à celle de la surface à éclairer de ladite tranche semi-conductrice, chacune desdites sources ponctuelles (2) étant modulée sinusoïdalement par un modulateur électrique commun (3), la distance (d) entre deux source ponctuelles et la distance (D) entre ladite source et la surface à éclairer de ladite tranche semi-conductrice étant choisies de sorte que ledit faisceau lumineux monochromatique éclaire de manière uniforme ladite surface à éclairer de ladite tranche semi-conductrice.

2. Source lumineuse selon la revendication 1, **caractérisée en ce que** ledit modulateur électrique (3) module chacune desdites sources ponctuelles dans une gamme de fréquence comprise entre 1 Hz et 100kHz.

3. Source lumineuse selon les revendications 1 et 2, **caractérisée en ce que** chaque source ponctuelle est une diode laser fibrée.

4. Source lumineuse selon la revendication 3, **caractérisée en ce qu'**une lentille de focalisation est placée en sortie de chaque diode laser fibrée.

5. Source lumineuse selon l'une quelconque des revendications 1 à 4, **caractérisée en ce que** chaque source ponctuelle est une diode électroluminescente.

6. Source lumineuse selon les revendications 1 à 5, **caractérisée en ce que** la distance d'intervalle (d) entre deux sources ponctuelles est comprise entre 0cm et 1.5cm.

7. Source lumineuse selon les revendications 4 et 6, **caractérisée en ce que** la distance de focalisation des lentilles est quelconque.

8. Source lumineuse selon les revendications 5 et 6, **caractérisée en ce que** l'angle d'émission a desdites diodes électroluminescentes est quelconque.

9. Source lumineuse selon l'une quelconque des revendications 1 à 8, **caractérisée en ce que** ladite source (1) est placée face à la surface à éclairer de ladite tranche semi-conductrice (4).

10. Source lumineuse selon l'une quelconque des revendications 1 à 8, **caractérisée en ce que** ladite source (1) est placé à 90° par rapport à la surface à éclairer de ladite tranche semi-conductrice (4), le faisceau lumineux émis par ladite source (1) étant renvoyé au moyen d'un miroir de renvoi (5) placé à 45° entre ladite source (1) et ladite surface à éclairer de ladite tranche semi-conductrice (4).

11. Source lumineuse selon l'une quelconque des revendications 1 à 10, **caractérisée en ce qu'**un filtre neutre de diffusion (6) est placé entre ladite source (1) et ladite surface à éclairer de ladite tranche semi-conductrice (4) afin de rendre le faisceau lumineux émis par ladite source plus uniforme.

12. Dispositif de mesure comprenant une source lumineuse selon l'une quelconque des revendications précédentes pour déterminer la durée de vie volumique τ_{b} et la vitesse de recombinaison S d'une tranche semi-conductrice (4), **caractérisé en ce que** ledit dispositif comprend en outre :
- ledit modulateur électrique (3) comportant une sortie (15) pour alimenter ladite source lumineuse et une sortie de signal de référence (7) en phase et de fréquence identique à la fréquence f de modulation de ladite source lumineuse,
- une source sonde (8) pour créer un champ d'ondes, les ondes émises irradiant la face non éclairée de ladite tranche semi-conductrice (4),
- un guide d'onde ou une antenne (9) permettant d'acheminer les ondes émises (10) sur la face non éclairée de ladite tranche semi-conductrice et les ondes réfléchies (11) vers un détecteur d'ondes (12), ledit guide d'onde ou ladite antenne associé audit détecteur d'ondes étant destiné à recueillir le signal produit par les ondes réfléchies par ladite tranche semi-conductrice ainsi excitée (4),
- une unité de contrôle (13) recevant le signal de référence provenant d'une des deux sorties dudit modulateur électrique et le signal onde réfléchi à la sortie dudit détecteur (12), mesurant ainsi un déphasage Δφ entre la source lumineuse et les ondes réfléchies,
- une unité de traitement (14) recevant le déphasage Δφ mesuré par ladite unité de contrôle (13) pour extraire au moins deux paramètres de ladite tranche semi-conductrice (4) qui sont la durée de vie des porteurs minoritaires τ_{b} et la vitesse de recombinaison superficielle S.

13. Dispositif de mesure selon la revendication 12, **caractérisé en ce que** ladite source lumineuse (1) émet un faisceau lumineux d'une puissance suffisante permettant une injection de porteurs libres au moins supérieure à 10⁻⁵ fois le dopage de ladite tranche semi-conductrice (4).

14. Dispositif selon la revendication 12, **caractérisé en ce que** ladite source sonde est une source micro-onde, travaillant en bande X, pour créer un champ micro-onde, les micro-ondes émises irradiant la face non éclairée de ladite tranche semi-conductrice (4).

15. Dispositif selon la revendication 12, **caractérisé en ce que** ladite source d'onde sonde est une source radiofréquence, travaillant dans un spectre radio fréquence compris entre la bande VHF et la bande X, les ondes émises irradiant la face non éclairée de ladite tranche semi-conductrice (4).

## Claims

1. A light source intended to inject excess carriers into a semiconductor wafer by illuminating a surface of said semiconductor wafer (4), said source being associated with a measuring device for characterising said semiconductor wafer, **characterised in that** said source (1) comprises at least one set of point sources (2) spaced apart at regular intervals in the direction X and in the direction Y, so that said source emits a monochromatic beam the size of which is at least equal to that of the surface to be illuminated of said semiconductor wafer, each of said point sources (2) being modulated sinusoidally by a common electrical modulator (3), the distance (d) between two point sources and the distance (D) between said source and the surface to be illuminated of said semiconductor wafer being chosen so that said monochromatic light beam uniformly illuminates said surface to be illuminated of said semiconductor wafer.

2. A light source according to claim 1, **characterised in that** said electrical modulator (3) modulates each of said point sources in a frequency range of between 1 Hz and 100 kHz.

3. A light source according to claims 1 and 2, **characterised in that** each point source is a fibrous laser diode.

4. A light source according to claim 3, **characterised in that** a focussing lens is placed at the exit of each fibrous laser diode.

5. A light source according to any one of claims 1 to 4, **characterised in that** each point source is a light emitting diode.

6. A light source according to claims 1 to 5, **characterised in that** the gap distance (d) between two point sources is between 0 cm and 1.5 cm.

7. A light source according to claims 4 and 6, **characterised in that** the focussing distance of the lenses is any distance.

8. A light source according to claims 5 and 6, **characterised in that** the emission angle α of said light emitting diodes is any angle.

9. A light source according to any one of claims 1 to 8, **characterised in that** said source (1) is placed facing the surface to be illuminated of said semiconductor wafer (4).

10. A light source according to any one of claims 1 to 8, **characterised in that** said source (1) is placed at 90° with respect to the surface to be illuminated of said semiconductor wafer (4), the light beam emitted by said source (1) being returned by means of a return mirror (5) placed at 45° between said source (1) and said surface to be illuminated of said semiconductor wafer (4).

11. A light source according to any one of claims 1 to 10, **characterised in that** a neutral diffusion filter (6) is placed between said source (1) and said surface to be illuminated of said semiconductor wafer (4) in order to make the light beam emitted by said source more uniform.

12. A measuring device comprising a light source according to any one of the preceding claims for determining the volume lifetime τ_{b} and the recombination rate S of a semiconductor wafer (4), **characterised in that** said device also comprises:
- said electrical modulator (3) comprising an output (15) for supplying said light source and a reference signal output (7) in phase and with a frequency identical to the modulation frequency f of said light source,
- a sensor source (8) for creating a wave field, the waves emitted irradiating the non-illuminated face of said semiconductor wafer (4),
- a waveguide or an antenna (9) for routing the waves emitted (10) onto the non-illuminated face of said semiconductor wafer and the reflected waves (11) to a wave detector (12), said waveguide or said antenna associated with said wave detector being intended to collect the signal produced by the waves reflected by said semiconductor wafer thus excited (4),
- a control unit (13) receiving the reference signal coming from one of the two outputs of said electrical modulator and the wave signal reflected at the output of said detector (12), thus measuring a phase difference Δφ between the light source and the reflected waves,
- a processing unit (14) receiving the phase difference ΔΦ measured by said control unit (13) in order to extract at least two parameters of said semiconductor wafer (4), which are the lifetime of the minority carriers τ_{b} and the surface recombination rate S.

13. A measuring device according to claim 12, **characterised in that** said light source (1) emits a light beam of sufficient power allowing injection of free carriers at least greater than 10⁻⁵ times the doping of said semiconductor wafer (4).

14. A device according to claim 12, **characterised in that** said sensor source is a microwave source, working in band X, in order to create a microwave field, the microwaves emitted irradiating the non-illuminated face of said semiconductor wafer (4).

15. A device according to claim 12, **characterised in that** said sensor wave source is a radio-frequency source, working in a radio-frequency spectrum lying between the VHF band and the X band, the waves emitted irradiating the non-illuminated face of said semiconductor wafer (4).

## Patentansprüche

1. Lichtquelle, die dazu bestimmt ist, in einem Halbleiter-Wafer überschüssige Träger zu injizieren, indem eine Oberfläche des Halbleiter-Wafers (4) beleuchtet wird, wobei der Quelle eine Messvorrichtung zum Kennzeichnen des Halbleiter-Wafers zugeordnet ist, **dadurch gekennzeichnet, dass** die Quelle (1) wenigstens eine Anordnung aus Punktquellen (2) umfasst, die in X-Richtung und in Y-Richtung in regelmäßigen Intervallen beabstandet sind, derart, dass die Quelle ein monochromatisches Bündel aussendet, dessen Abmessung wenigstens gleich jener der zu beleuchtenden Oberfläche des Halbleiter-Wafers ist, wobei jede der Punktquellen (2) durch einen gemeinsamen elektrischen Modulator (3) sinusförmig moduliert wird, wobei der Abstand (d) zwischen zwei Punktquellen und der Abstand (D) zwischen der Quelle und der zu beleuchtenden Oberfläche des Halbleiter-Wafers in der Weise gewählt sind, dass das monochromatische Lichtstrahlenbündel die zu beleuchtende Oberfläche des Halbleiter-Wafers gleichmäßig beleuchtet.

2. Lichtquelle nach Anspruch 1, **dadurch gekennzeichnet, dass** der elektrische Modulator (3) jede der Punktquellen in einem Frequenzbereich von 1 Hz bis 100 kHz moduliert.

3. Lichtquelle nach den Ansprüchen 1 und 2, **dadurch gekennzeichnet, dass** jede Punktquelle eine Faser-Laserdiode ist.

4. Lichtquelle nach Anspruch 3, **dadurch gekennzeichnet, dass** am Ausgang jeder Faser-Laserdiode eine Fokussierungslinse angeordnet ist.

5. Lichtquelle nach einem der Ansprüche 1 bis 4, **dadurch gekennzeichnet, dass** jede Punktquelle eine Leuchtdiode ist.

6. Lichtquelle nach den Ansprüchen 1 bis 5, **dadurch gekennzeichnet, dass** der Intervallabstand (d) zwischen zwei Punktquellen im Bereich von 0 cm bis 1,5 cm liegt.

7. Lichtquelle nach den Ansprüchen 4 und 6, **dadurch gekennzeichnet, dass** die Brennweite der Linsen beliebig ist.

8. Lichtquelle nach den Ansprüchen 5 und 6, **dadurch gekennzeichnet, dass** der Emissionswinkel α der Leuchtdioden beliebig ist.

9. Lichtquelle nach einem der Ansprüche 1 bis 8, **dadurch gekennzeichnet, dass** die Quelle (1) gegenüber der zu beleuchtenden Oberfläche des Halbleiter-Wafers (4) angeordnet ist.

10. Lichtquelle nach einem der Ansprüche 1 bis 8, **dadurch gekennzeichnet, dass** die Quelle (1) unter 90° in Bezug auf die zu beleuchtende Oberfläche des Halbleiter-Wafers (4) angeordnet ist, wobei das Lichtstrahlenbündel, das von der Quelle (1) ausgesendet wird, mittels eines Umlenkspiegels (5), der unter 45° zwischen der Quelle (1) und der zu beleuchtenden Oberfläche des Halbleiter-Wafers (4) angeordnet ist, ausgesendet wird.

11. Lichtquelle nach einem der Ansprüche 1 bis 10, **dadurch gekennzeichnet, dass** ein (6) zwischen der Quelle (1) und der zu beleuchtenden Oberfläche des Halbleiter-Wafers (4) Diffusionsneutralfilter angeordnet ist, um das von der Lichtquelle ausgesendete Lichtstrahlenbündel gleichmäßiger zu machen.

12. Messvorrichtung, die eine Lichtquelle nach einem der vorhergehenden Ansprüche umfasst, um die Volumen-Lebensdauer τ_{b} und die Rekombinationsgeschwindigkeit S eines Halbleiter-Wafers (4) zu bestimmen, **dadurch gekennzeichnet, dass** die Vorrichtung außerdem umfasst:
- den elektrischen Modulator (3), der einen Ausgang (15) zum Versorgen der Lichtquelle und einen Referenzsignalausgang (7) mit einer Phase und einer Frequenz, die gleich der Modulationsfrequenz f der Lichtquelle ist, umfasst,
- eine Sondenquelle (8), um ein Wellenfeld zu erzeugen, wobei die ausgesendeten Wellen die nicht beleuchtete Fläche des Halbleiter-Wafers (4) bestrahlen,
- einen Wellenleiter oder eine Antenne (9), der/die die ausgesendeten Wellen (10) zu der nicht beleuchteten Fläche des Halbleiter-Wafers und die reflektierten Wellen (11) zu einem Wellendetektor (12) führt, wobei der Wellenleiter oder die Antenne, dem/der der Wellendetektor zugeordnet ist, dazu bestimmt ist, das Signal zu empfangen, das von den Wellen erzeugt wird, die durch den auf diese Weise erregten Halbleiter-Wafer (4) reflektiert werden,
- eine Steuereinheit (13), die das von einem der zwei Ausgänge des elektrischen Modulators stammende Referenzsignal und das Signal der am Ausgang des Detektors (12) reflektierten Welle empfängt und **dadurch** die Phasenverschiebung Δφ zwischen der Lichtquelle und den reflektierten Wellen misst,
- eine Verarbeitungseinheit (14), die die von der Steuereinheit (13) gemessene Phasenverschiebung Δφ empfängt, um daraus wenigstens zwei Parameter des Halbleiter-Wafers zu extrahieren, die die Lebensdauer τ_{b} der Minoritätsträger bzw. die Oberflächenrekombinationsgeschwindigkeit S sind.

13. Messvorrichtung nach Anspruch 12, **dadurch gekennzeichnet, dass** die Lichtquelle (1) ein Lichtstrahlenbündel mit einer Leistung aussendet, die ausreicht, um die Injektion freier Träger wenigstens oberhalb der 10⁻⁵-fachen Dotierung des Halbleiter-Wafers (4) zu ermöglichen.

14. Vorrichtung nach Anspruch 12, **dadurch gekennzeichnet, dass** die Sondenquelle eine Mikrowellenquelle ist, die im X-Band arbeitet, um ein Mikrowellenfeld zu erzeugen, wobei die ausgesendeten Mikrowellen die nicht beleuchtete Fläche des Halbleiter-Wafers (4) bestrahlen.

15. Vorrichtung nach Anspruch 12, **dadurch gekennzeichnet, dass** die Sondenwellenquelle eine Hochfrequenzquelle ist, die in einem Hochfrequenzspektrum arbeitet, das zwischen dem VHF-Band und dem X-Band liegt, wobei die ausgesendeten Wellen die nicht beleuchtete Fläche des Halbleiter-Wafers (4) bestrahlen.
